Europäisches Patentamt

European Patent Office

Office européen des brevets

(19)

(11) Veröffentlichungsnummer : **0 072 456**
**B1**

(12) EUROPÄISCHE PATENTSCHRIFT

(45) Veröffentlichungstag der Patentschrift :
17.07.85

(21) Anmeldenummer : 82106706.3

(22) Anmeldetag : 24.07.82

(51) Int. Cl.⁴ : **C 23 F 1/00, C 23 G 1/10,**
**C 09 K 13/04// H05K3/06**

(54) Stripperlösung.

(30) Priorität : 17.08.81 DE 3132427
06.03.82 DE 3208124

(43) Veröffentlichungstag der Anmeldung :
23.02.83 Patentblatt 83/08

(45) Bekanntmachung des Hinweises auf die Patenterteilung : 17.07.85 Patentblatt 85/29

(84) Benannte Vertragsstaaten :
AT BE CH FR GB IT LI NL SE

(56) Entgegenhaltungen :
DE-A- 1 915 405
DE-A- 2 510 247
DE-B- 2 537 757
US-A- 3 562 040

(73) Patentinhaber : ELGET ING.- BÜRO FÜR GRAFISCHE
UND ELEKTRONISCHE TECHNIK
Niederdorf 32
D-8981 Obermaiselstein (DE)

(72) Erfinder : Die Erfinder haben auf ihre Nennung
verzichtet

(74) Vertreter : König, Reimar, Dr.-Ing. et al
Patentanwälte Dr.-Ing. Reimar König Dipl.-Ing. Klaus
Bergen Wilhelm-Tell-Strasse 14 Postfach 260162
D-4000 Düsseldorf 1 (DE)

## Beschreibung

Die Erfindung bezieht sich auf eine Stripperlösung zum Entfernen von Zinn und Zinnlegierungen, insbesondere Metallresist von Kupfer, insbesondere bei gedruckten Schaltungen.

Beim Herstellen gedruckter, durchmetallisierter Schaltungen werden die aus Kupfer bestehenden Leiterbahnen und Kontaktlöcher der Basisplatte üblicherweise in Hochglanzzinn- oder Blei-, Zinn-Legierungsbädern mit etwa 60 % Zinn und 40 % Blei galvanisch veredelt, um einen korrosionsbeständigen metallischen Schutz zu schaffen. Dabei wird auf die Kupferleiterbahnen eine Zinn- bzw. Legierungsschicht von 6 bis 12 μm aufgebracht. Diese gewährleistet eine hohe Anlauf- und Korrosionsbeständigkeit bei guter Lötbarkeit und weitgehender Porenfreiheit. Gleichzeitig dient die Zinnschicht auch als Ätzresist beim Entfernen der Kupfergrundkaschierung durch selektives alkalisches Ätzen.

Reine Zinnschichten unterliegen jedoch je nach Beanspruchung der Gefahr einer Whiskerbildung oder auch Zinnpest. Dabei werden von vielen Herstellern heute Zinn-Blei-Überzüge bevorzugt, deren Lötbarkeit jedoch nach langer Lagerzeit stark abfällt. Um die Lagerbeständigkeit zu erhöhen und die Lötbarkeit zu erhalten, ist es bekannt, die Legierungsschicht nach dem Wegätzen der Kupferleitschicht einem Nachschmelzen in einem Ölbad oder Infrarot-Ofen zu unterwerfen.

Anschließend werden die Leiterplatten ein- oder beidseitig mit einer Lötzstopplack-Maske versehen. Dabei bleiben nur die Lötaugen offen und wird die Leiterplatte gegen die Lötwärme geschützt.

Werden solche glanz- oder mischverzinnte bzw. auch aufgeschmolzene Leiterplatten mit Bauelementen bestückt und diese anschließend in den Kontaktöffnungen verlötet, dann kommt es häufig zu dem sogenannten Kräuseleffekt. Diese Kräuseleffekt ist dadurch bedingt, daß beim Löten das unter der Lötstopplack-Maske befindliche Zinn wegen seines niedrigen Schmelzpunktes zum Schmelzen kommt und dabei infolge Volumenvergrößerung bzw. -veränderung die Lackschicht verformt. Um diesen Nachteil zu vermeiden, bedient sich die Praxis mehr und mehr der Heißverzinnung (hot-air-leveling), bei der die Lötstopplack-Maske direkt auf die Leiterbahnen aus schwach oxydiertem Kupfer oder desoxydiertem Reinkupfer gebracht wird. Die gebohrten Leiterplatten werden dabei in galvanischen Kupferbädern durchkontaktiert und anschließend mittels saurer oder alkalischer Medien geätzt, um das Leiterbild mit seinen Lötaugen und durchkontaktierten Bohrlöchern zu schaffen. Danach wird dann der Lötstopplack aufgebracht und anschließend ein eutektisches Lot in die Lötaugen gebracht, ohne daß es zu dem Kräuseleffekt kommen kann.

Zum Herstellen der kupferdurchkontaktierten Leiterplatten sind verschiedene Verfahren bekannt, von denen sich das eingangs erwähnte Herstellen des Leiterbildes mittels eines Metall-Resists im Wege einer Verzinnung und des späteren Zinnentfernens mit Hilfe eines Strippers am meisten bewährt hat. Dabei wird auf der verkupferten Leiterplatte mit Hilfe eines Galvanoresists im Siebdruckverfahren oder eines Fest- oder Flüssigresists fotografisch das Leiterbild mittels einer Glanz- oder Mattglanz-Zinnschicht aufgebaut und gleichzeitig das betreffende Metallresist an den Lötaugen und in den Lötlöchern mit einer Schichtdicke von 2 bis 4 μm abgeschieden, um die Leiterbahnen und durchkontaktierten Lötlöcher beim alkalischen Ätzen hinreichend zu schützen.

So vorteilhaft dieses Aufbringen des Zinns als metallisches Ätzeresist beim Herstellen heißverzinnter Leiterplatten ist, so sind für das spätere Entfernen der Zinn- bzw. Zinnlegierungsschicht spezielle Stripper erforderlich, die das Kupfer der Leiterbahnen nich allzustark angreifen. Bei den bekannten Zinnstrippern handels es sich um saure Medien, im allgemeinen Säuren wie Borfluorwasserstoffsäure und Salpetersäure. Diese Säuren sind jedoch äußerst aggressiv und greifen daher Metall wie Aluminium, Stahl, Edelstähle und selbst Titan an. Demzufolge kommen bei derartigen Strippern nur solche Anlagen infrage, deren mit dem Stripper in Berührung kommenden Teile wie Pumpen, Förderer, Leitungen und Ventile aus Kunststoff bestehen oder, soweit überhaupt möglich, mit Kunststoff beschichtet sind. Demzufolge lassen sich bei diesem Verfahren die üblichen Entmetallisierungsvorrichtungen nicht verwenden und sind entsprechend hohe Sonderinvestitionen erforderlich.

Schwefelsäurestripper erfordern zudem eine Badtemperatur von 80 bis 90 °C und demgemäß spezielle Heizvorrichtungen aus Bleischlangen, Graphitrohren oder Porzellan. Als weiterer Nachteil kommt die hohe Giftigkeit der Stripper hinzu, die besondere Schutzmaßnahmen und eine sorgfältige Aufbereitung bzw. Entgiftung und Neutralisierung der verbrauchten Lösungen erforderlich macht. Das geschieht beispielsweise mit Kaliumsulfatlösungen und Natronlauge, wobei der sich abscheidende Blei- und Zinnschlamm abfiltriert und in eine Sonderdeponie verbracht werden muß. Schließlich muß dann noch das Filtrat mit verdünnter Schwefelsäure auf eine pH-Wert von etwa 8 eingestellt und mit einer erheblichen Menge Wasser verdünnt werden.

Es sind zwar auch andere saure oder alkalische Zinnstripper bekannt ; diese eignen sich jedoch wegen der erförderlichen höheren Badtemperatur oder ihrer Aggressivität gegenüber Metallen, aber auch Kunststoffen nicht zum Entmetallisieren von Leiterplatten.

Der Erfindung liegt daher die Aufgabe zugrunde, eine Stripperlösung zu schaffen, die keine besonderen Apparaturen erfordert, äußerst preiswert ist und keinerlei Abwasserbelastung mit sich bringt sowie auf einfache Weise ein Rückgewinnen des gestrippten Metalls erlaubt. Die Lösung dieser Aufgabe besteht in einer Stripperlösung aus einer wässrigen zinnhaltigen Lösung mit 5 bis 20, vorzugsweise 10 Vol.-% Salzsäure, 2,5 bis 6,0 g/l, vorzugsweise 3,5 bis 4 g/l Kupfer und unter 40 g/l Zinn.

Die erfindungsgemäße salzsaure kupfer- und zinnhaltige Stripperlösung erlaubt die Verwendung üblicher Spül-, Sprüh- und Sumpfunterbaumodule, beispielsweise übliche Sprüh- und Spülmodule mit Flach-, Rundstrahl- oder Quadratstrahldüsen oder stehenden Düsenwellen. Diese handelsüblichen Module lassen sich auf einfache Weise nachrüsten oder zu einer besonderen Stripperlinie zusammenfassen, ohne daß irgendwelche besonderen Maßnahmen erforderlich wären, weil die üblichen Werkstoffe auch in Anwesenheit geringer Kupfer- und Zinn- bzw. Zinn-Legierungsmengen hinreichend salzsäurebeständig sind.

Von großem Vorteil ist auch die geringe Toxizität der erfindungsgemäßen Stipperlösung, die keine besonderen Schutzmaßnahmen erforderlich macht.

Ein weiterer Vorteil resultiert schließlich daraus, daß die erfindungsgemäße Stripperlösung insbesondere auch die beim Verzinnen entstehenden intermetallischen Kupfer-Zinn-Verbindungen im Bereich der Grenzfläche Kupfer/Zinn bzw. Zinnlegierungen auflöst. Derartige intermetallische Verbindungen entstehen bei länger gelagerten verzinnten Leiterplatten und lassen sich mit den herkömmlichen Borfluorwasserstoffsäure- oder Salpetersäurestrippern nicht entfernen.

Die Anwesenheit von 2,5 bis 6,0 g/l Kupfer in einer 5 bis 20-volumenprozentigen Salzsäure gewährleistet ein einwandfreies Strippen der Glanz- und Mattzinnschichten ohne Gefahr für die darunter befindlichen Leiterbahnen aus Kupfer. Das in der Stripperlösung enthaltene Kupfer-(II)-Chlorid wird beim Strippen zu Kupfer-(I)-Chlorid reduziert und muß anschließend wieder rückoxydiert werden. Dies geschieht anfänglich, d. h. bei Beginn des Strippens mit Hilfe eines Zusatzes von 0,5 ml/l Wasserstoffperoxyd, dessen freigesetztes Sauerstoffatom das Kupfer-(I)-Chlorid rückoxydiert, so daß die Lösung praktisch frei von Kupfer-(I)-Chlorid-Ionen gehalten wird. Wenn das Wasserstoffperoxyd verbraucht ist, dann hat sich die Stripperlösung während des Besprühens der Leiterplatten soweit mit Luftsauerstoff angereichert, daß das Entstehen von Kupfer-(I)-Chlorid auf diese Weise unterdrückt wird.

Des weiteren kann die Stipperlösung anstelle des Wasserstoffperoxyds zu Beginn des Strippens bis 0,015 ml/l eines Tensids bzw. eines vorzugsweise säurebeständigen Netzmittels beispielsweise auf Basis von Alkylpolyglykoläther, Fettsäurepolyglykoläther, Alkoxylaten, Perfluorcarbon- und Perfluorsulfonsäuren enthalten. Tenside in dieser Konzentration haben sich wegen ihrer guten Löslichkeit in Wasser und ihrer Grenzflächenaktivität außerordentlich bewährt, sie sollten vorzugsweise säurebeständig sein.

Steigt hingegen der Kupfergehalt des Stripperbades über 6,0 g/l, dann reicht der Luftsauerstoff nicht mehr aus, und wird die Lösung instabil, ohne daß ein Kupfer-(II)-Chlorid-Zusatz Abhilfe schaffen könnte. Vielmehr kommt es bei einem derartigen Zusatz zu einem unerwünschten Angriff auf das Kupfer der Leiterbahnen. Zur Aufrechterhaltung der Wirksamkeit der Stripperlösung braucht lediglich die Salzsäure- und die Kupferkonzentration konstant gehalten zu werden. Das geschieht durch kontinuierliches Zudosieren von Salzsäure mittels üblicher Dosierpumpen sowie durch ein Entmetallisieren mit Hilfe einer galvanischen Metall-Rückgewinnungszelle, die den Zinngehalt des Bades vorzugsweise bei 9 bis 40 g/l, beispielsweise bei 10 bis 12 g/l konstant hält. Die Rückgewinnungszelle kann dabei im Bypass angeordnet sein, um die entzinnte Lösung wieder in das Bad zurückführen zu können. Andererseits läßt sich die entzinnte Lösung jedoch auch mit Hilfe eines üblichen Ionenaustauschers oder einer gängigen Neutralisierung aufbereiten und alsdann in die Kanalisation einleiten.

Da sich das Kupfer nicht verbraucht, ergibt sich lediglich eine ganz leichte Erhöhung der Kupferkonzentration durch ein nicht zu vermeidendes minimales Lösen des Kupfers der Leiterbahnen. Der damit verbundenen Erhöhung der Kupferkonzentration wirkt jedoch das Nachdosieren der Salzsäure entgegen. Andererseits ließe sich der Kupfergehalt des Bades aber auch mit Hilfe einer Metall-Rückgewinnungszelle bei dem erforderlichen Wert von 2,5 bis 6,0 g/l konstant halten.

Die Pumpen für das Nachdosieren der Salzsäure lassen sich in üblicher Weise in Abhängigkeit vom Plattendurchlauf, beispielsweise mit Hilfe einer Lichtschranke, steuern, während sich die Konzentration des Zinns und des Kupfers im Stripperbad calorimetrisch oder mit Hilfe eines Redox-Potentials überwachen bzw. steuern lassen.

Die erforderliche Salzsäure wird vorzugsweise in einer Menge von 10 bis 12 l/h je 100 Liter Tankinhalt der Stripperlösung zugeführt. Der Kupfergehalt der Stripperlösung bleibt im wesentlichen konstant, da dem Kupferabbau eine entsprechende Kupferaufnahme während des Abätzens der Zinnlegierung gegenübersteht. Damit wird auch der Kupferverlust ausgeglichen, der sich daraus ergibt, daß eine dem Salzsäurezufluß entsprechende Stripperlösungsmenge aus dem Behandlungsmitteltank abfließt.

Die Erfindung wird nachfolgend anhand zweier Ausführungsbeispiele des näheren erläutert:

um 100 l der erfindungsgemäßen Stripperlösung herzustellen, wurden zunächst 941,5 g Kupfer-(II)-Chlorid in etwa 70 l Wasser gelöst und in diese Lösung 13 l konzentrierte Salzsäure sowie 2.280 g Zinn-(II)-Chlorid gegeben. Die Lösung wurde alsdann mit Wasser auf 100 l ver-

dünnt, mit 1,5 ml eines Tensids versetzt und schließlich 15 Minuten in einer Stripperanlage durchgearbeitet sowie anschließend bei Raumtemperatur zum Entfernen einer Zinnlegierung aus 60 % Zinn und 40 % Blei von einer Kupfer-Leiterplatte eingesetzt. Eine Analyse der Stripperlösung ergab 3,5 g/l Kupfer, 12 g/l Zinn und 130 ml/l HCL. Die Ablösegeschwindigkeit lag bei 4 bis 5 μm/min. bei einer Durchlaufgeschwindigkeit von 0,6 m/min.

Bei einem weiteren Versuch wurden ebenfalls 941,5 g Kupfer-(II)-Chlorid in etwa 70 l Wasser aufgelöst und in die Lösung 13 l konzentrierte Salzsäure gegeben. Diese Grundlösung wurde dann in den Tank einer Stripperanlage gegeben, in deren Sprühzone sich 1,2 kg Reinzinnanoden-Reste befanden, um den erforderlichen Zinngehalt der Stripperlösung ohne die Verwendung eines löslichen Zinnsalzes einzustellen. Nach etwa zweistündigem Besprühen war das Zinn völlig aufgelöst und wurde die Lösung mit Wasser auf 100 l aufgefüllt. Eine Analyse der Stripperlösung ergab 3,5 g/l Kupfer, 12 g/l Zinn und 130 ml/l Salzsäure. Nach einem Zusatz von 1,5 ml eines Tensids war die Stripperlösung gebrauchsfertig ; sie wurde in derselben Stripperanlage zum Strippen von Zinn eingesetzt und ergab im Dauerversuch eine Ablösegeschwindigkeit von 4 bis 5 μm/min. bei einer Durchlaufgeschwindigkeit von 0,6 m/min.

## Patentansprüche

1. Stripperlösung zum Entfernen von Zinn und Zinnlegierungen von Kupfer insbesondere bei gedruckten Schaltungen, bestehend aus einer wässrigen zinnhaltigen Lösung mit 5 bis 20 Vol.-% Salzsäure, 2,5 bis 6,0 g/l Kupfer und unter 40 g/l Zinn.

2. Verfahren zum Entfernen von Zinn und Zinnlegierungen von Kupfer insbesondere bei gedruckten Schaltungen unter Verwendung einer Stripperlösung nach Anspruch 1, dadurch gekennzeichnet, daß die Stripperlösung anfangs mit 0,5 ml/l Wasserstoffperoxyd oder bis 0,015 ml/l eines Tensids versetzt und auf das zu entmetallisierende Kupfer aufgesprüht wird.

3. Verfahren nach Anspruch 2, dadurch gekennzeichnet, daß der Zinngehalt der Stripperlösung bei 9 bis 40 g/l konstant gehalten wird.

4. Verfahren nach Anspruch 2 oder 3, dadurch gekennzeichnet, daß der Zinn- und der Kupfergehalt der Stripperlösung calorimetrisch oder mit Hilfe einer Redox-Potential-Steuerung konstant gehalten werden.

5. Verfahren nach einem oder mehreren der Ansprüche 2 bis 4, dadurch gekennzeichnet, daß die Stripperlösung mit Hilfe einer galvanischen Metall-Rückgewinnungszelle entzinnt und/oder entkupfert wird.

6. Verfahren nach einem oder mehreren der Ansprüche 1 bis 5, dadurch gekennzeichnet, daß der Stripperlösung kontinuierlich Salzsäure zugeführt wird.

## Claims

1. Stripper solution for removing tin and tin alloys from copper, especially in the case of printed circuits, consisting of an aqueous tin-containing solution comprising 5 to 20 % by vol. hydrochloric acid, 2.5 to 6.0 g/l copper and less than 40 g/l tin.

2. Process for the removal of tin and tin alloys from copper, especially in the case of printed circuits, using a stripper solution according to Claim 1, characterized in that 0.5 ml/l hydrogen peroxide or up to 0.015 ml/l of a tenside is first added to the stripper solution and the solution is sprayed onto the copper to be deposited out.

3. Process according to Claim 2, characterized in that the tin content of the stripper solution is kept constant at 9 to 40 g/l.

4. Process according to Claim 2 or 3, characterized in that the tin content and the copper content of the stripper solution are kept constant by calorimetric means or by means of a redox potential control.

5. Process according to one or more of claims 2 to 4, characterized in that the stripper solution has the tin and/or copper removed from it by means of a galvanic metal recovery cell.

6. Process according to one or more of claims 1 to 5, characterized in that hydrochloric acid is continuously fed to the stripper solution.

## Revendications

1. Solution de décapage pour l'élimination de l'étain et des alliages d'étain recouvrant du cuivre, notamment dans les circuits imprimés, caractérisée en ce qu'elle est constituée par une solution aqueuse contenant de l'étain avec 5 à 20 % en volume d'acide chlorhydrique, 2,5 à 6,0 g/l de cuivre et moins de 40 g/l d'étain.

2. Procédé d'élimination de l'étain et des alliages d'étain recouvrant du cuivre, notamment dans les circuits imprimés, en utilisant la solution de décapage selon la revendication 1, caractérisé en ce que la solution de décapage est additionnée au début de 0,5 ml/l d'eau oxygénée ou jusqu'à 0,015 ml/l d'un agent tensio-actif et est répandue sur le cuivre à démétalliser.

3. Procédé selon la revendication 2, caractérisé en ce que la teneur en étain de la solution de décapage est maintenue constante à une valeur de 9 à 40 g/l.

4. Procédé selon l'une des revendications 2 ou 3, caractérisé en ce que la teneur en étain et en cuivre de la solution de décapage est maintenue constante par calométrie ou à l'aide d'une commande du potentiel redox.

5. Procédé selon l'une des revendications 2 à 4, caractérisé en ce que la solution de décapage est débarrassée de son étain et/ou de son cuivre par une cellule galvanique de récupération de métal.

6. Procédé selon l'une des revendications 1 à 5, caractérisé en ce que la solution de décapage reçoit continuellement de l'acide chlorhydrique.